# EUROPEAN PATENT SPECIFICATION

(11) **EP 2 065 364 B1**
(45) Date of publication and mention of the grant of the patent: **01.08.2012**
(21) Application number: 08170027.0
(22) Date of filing: 26.11.2008
(51) Int. Cl.: C07C 251/04, C07C 251/08, C23C 16/00, C23C 16/18, C23C 16/40

(54) **Metal complexes of tridentate beta-ketoiminates**
Metallkomplexe aus Tridentat-beta-ketoiminaten
Complexes métalliques de bêta- kétoiminates

(30) Priority: 27.11.2007 US 945678; 03.10.2008 US 245196
(43) Date of publication of application: 03.06.2009
(73) Proprietor: Air Products and Chemicals, Inc., Allentown, PA 18195-1501 (US)
(72) Inventor: Lei, Xinjian, Vista, CA 92081 (US); Spence, Daniel P., Carlsbad, CA 92008 (US); Cheng, Hansong, Allentown, PA 18106 (US)
(74) Representative: Muir, Benjamin M. J.

(56) References cited:
- EP-A- 1 273 683
- EP-A- 1 676 850
- EP-A- 1 849 789

## Description

### BACKGROUND OF THE INVENTION

The semiconductor fabrication industry continues to demand novel metal source containing precursors for chemical vapor deposition processes including atomic layer deposition for fabricating conformal metal containing films on substrates such as silicon, metal nitride, metal oxide and other metal-containing layers using these metal-containing precursors.

EP-A-1,849,789 teaches metal-containing tridentate β-ketoiminates precursors that are useful for fabricating conformal metal containing films via deposition processes such as chemical vapor deposition and atomic layer deposition. Exemplary β-ketoiminates complexes taught in this document include compounds such as bis(2,2-dimethyl-5-(dimethylaminoethyl-imino)-3-hexanonato-N,O,N')strontium and bis(2,2-dimethyl-5-(dimethylaminoethyl-imino)-3-hexanonato-N,O,N')nickle. In said complexes, the β-ketoiminate ligand contains two nitrogen atoms and one oxygen atom that coordinate with the metal atom of the complex, the two nitrogen atoms of the ligand being connected by a linear alkylene bridge.

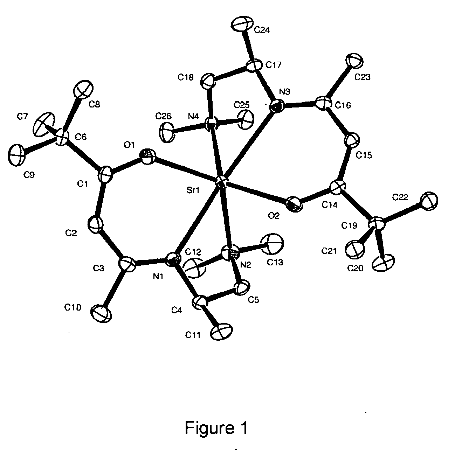

EP-A-1,676,850 teaches metal β-ketoiminate and β-diiminate complexes suitable for use as precursors to deposit metal-containing films via, for example, atomic layer deposition or chemical vapor deposition. An exemplary complex described therein is Cu(MeC(O)CHC(NCH₂CH₂OSiMe₂(C₂H₃))Me), in which the ligand (as depicted in Figure 1 of the document) coordinates with the copper atom via a nitrogen atom, oxygen atom and vinyl group, the nitrogen atom and vinyl group being connected by heteroalkyl bridge including a silyl group with methyl substituents (i.e. -CH₂CH₂OSi(Me₂)-).

### BRIEF SUMMARY OF THE INVENTION

This invention is directed to metal containing tridentate β-ketoiminates and solutions wherein the tridentate β-ketoiminates incorporate nitrogen or oxygen functionality in the imino group. The tridentate β-ketoiminates are selected from the structures: 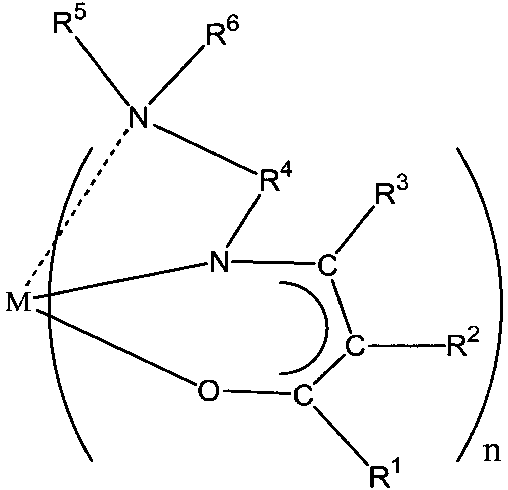 wherein M is a metal, preferably a metal having a valence of from 2 to 5. Examples of metals include calcium, magnesium, strontium, barium, scandium, yttrium, lanthanum, titanium, zirconium, vanadium, tungsten, manganese, cobalt, iron, nickel, ruthenium, zinc, copper, palladium, platinum, iridium, rhenium, and osmium. A variety of organo groups may be employed as for example wherein R¹ is selected from alkyl, alkoxyalkyl, fluoroalkyl, cycloaliphatic, and aryl, having from 1 to 10 carbon atoms, preferably a group containing 1 to 6 carbon atoms; R² is selected from hydrogen, alkyl, alkoxy, cycloaliphatic, and aryl; R³ is selected from alkyl, fluoroalkyl, alkoxyalkyl, cycloaliphatic, and aryl; R⁴ is a C3-10 branched alkyl or alkylene bridge having at least one chiral carbon atom, preferably a group containing 3 or 4 carbon atoms, thus making a five- or six-membered coordinating ring to the metal center; R⁵⁻⁶ are individually selected from alkyl, fluoroalkyl, cycloaliphatic, and aryl, or they can be connected thus forming a ring containing carbon and one or more nitrogen atoms and optionally one or more oxygen atoms (i.e. they can be connected to form a heterocyclic ring). The subscript n is an integer and equals the valence of the metal M. 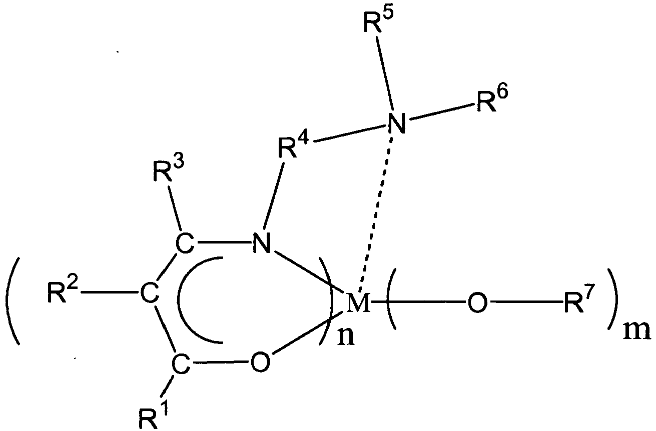 wherein M is a metal ion, preferably a metal ion selected from Group 4, 5 metals, examples including titanium, zirconium, and hafnium; wherein R¹ is selected from alkyl, alkoxyalkyl, fluoroalkyl, cycloaliphatic, and aryl, having from 1 to 10 carbon atoms, preferably a group containing 1 to 6 carbon atoms; R² is selected from hydrogen, alkyl, alkoxy, cycloaliphatic, and aryl; R³ is selected from alkyl, alkoxyalkyl, fluoroalkyl, cycloaliphatic, and aryl; R⁴ is a C3-10 branched alkyl or alkylene bridge having at least one chiral carbon atom, preferably a group containing 3 or 4 carbon atoms, thus making a five- or six-membered coordinating ring to the metal center; R⁵⁻⁶ are individually selected from alkyl, fluoroalkyl, cycloaliphatic, and aryl, or they can be connected thus forming a ring containing carbon and one or more nitrogen atoms and optionally one or more oxygen atoms (i.e. they can be connected to form a heterocyclic ring); R⁷ is selected from alkyl, fluoroalkyl, cycloaliphatic, and aryl; wherein m and n are each at least 1 and the sum of m + n is equal to the valence of the metal.

As noted above, R⁴ is a C₃₋₁₀ branched alkyl or alkylene bridge (i.e. one or more of the carbon atoms of R⁴ form a side chain to the bridge between the two nitrogens on either side of R⁴). R⁴ preferably forms a five-membered or six-membered coordinating ring with the metal center (i.e., there are two or three carbons, respectively, in the bridge between the two nitrogens).

In preferred embodiments: R¹ is a C₁₋₁₀ alkyl, more preferably a C₁₋₆ alkyl; R² is selected from hydrogen, a C₁₋₆ alkyl, and a C₆₋₁₀ aryl; R³ is selected from a C₁₋₆ alkyl, a C₁₋₆ fluoroalkyl, and a C₆₋₁₀ aryl; R⁴ is a C₃₋₁₀ branched alkyl or alkylene bridge having at least one chiral carbon atom, more preferably a C₃₋₄ branched alkyl or alkylene bridge having at least one chiral carbon atom; R⁵ is a C₁₋₃ alkyl; R⁶ is C₁₋₃ alkyl; and R⁷, where present, is a linear or branched alkyl, preferably a C₁₋₄ linear or branched alkyl.

In some embodiments R¹ is a C₁₋₅alky or a C₄₋₆ alkyl. R¹ may for example be methyl, t-butyl or t-pentyl.

In some embodiments R² is hydrogen or a C₁₋₆ alkyl. R² may for example be hydrogen, methyl or ethyl.

In some embodiments R³ is a C₁₋₆ alkyl. R³ may for example be methyl or ethyl.

In some embodiments R⁵ and R⁶ are each individually selected from methyl or ethyl.

In some embodiments R⁷ is selected from methyl, ethyl, propyl, iso-propyl, n-butyl, *sec*-butyl, iso-butyl, and *tert*-butyl.

Several advantages can be achieved through these metal-containing tridentate β-ketoiminates as precursors for chemical vapor deposition or atomic layer deposition, and these include:
an ability to form reactive complexes in good yield;
an ability to form monomeric complexes, particularly calcium and strontium complexes, coordinated with one kind of ligand, thus allowing one to achieve a high vapor pressure;
an ability to significantly increase the thermal stability of resulting metal complexes, due to the presence of the branched alkyl or alkylene bridge having at least one chiral carbon atom between the two nitrogen atoms, as compared to those metal complexes without chiral centers between the two nitrogen atoms
an ability to produce highly conformal metal thin films suited for use in a wide variety of electrical applications;
an ability to form highly conformal metal oxide thin films suited for use in microelectronic devices;
an ability to enhance the surface reaction between the metal-containing tridentate β-ketoiminates and the surface of a substrate due to the high chemical reactivity of the complexes.

### BRIEF DESCRIPTION OF THE DRAWINGS

Figure 1 is a drawing representative of the crystal structure of bis(2,2-dimethyl-5-(1-dimethylamino-2-propylimino)-3-hexanonato-N,O,N')strontium.
Figure 2 is a thermogravimetric analysis (TGA) diagram of bis(2,2-dimethyl-5-(1-dimethylamino-2-propylimino)-3-hexanonato-N,O,N')strontium (solid line) vs bis(2,2-dimethyl-5-(dimethylaminoethyl-imino)-3-hexanonato-N,O,N')strontium (dashed line), indicating the new Sr complex with a chiral center (solid line) is much more stable than that without chiral center between the two nitrogen atoms (dashed line), thus leaving almost no residue.
Figure 3 is a drawing representing the crystal structure of bis(2,2-dimethyl-5-(1-dimethylamino-2-propylimino)-3-hexanonato-N,O,N')nickel.
Figure 4 is a thermogravimetric analysis (TGA) diagram of bis(2,2-dimethyl-5-(1-dimethylamino-2-propylimino)-3-hexanonato-N,O,N')nickel (solid line) vs bis(2,2-dimethyl-5-(dimethylaminoethyl-imino)-3-hexanonato-N,O,N')nickel (dashed line), indicating the new Ni complex with a chiral center (solid line) is much more stable than that without chiral center between the two nitrogen atoms (dashed line), thus leaving less than 3% residue.
Figure 5 is a drawing representing the crystal structure of bis(4-(1-dimethylamino-2-propylimino)-2-pentanonato)nickel.
Figure 6 is a thermogravimetric analysis (TGA) and differential scanning calorimetry(DSC) diagram of bis(4-(1-dimethylamino-2-propylimino)-2-pentanonato)nickel, indicating the new Ni complex with a chiral center is volatile with low residue and also a low melting point (~100°C).
Figure 7 is a drawing representative of the crystal structure of bis(2,2-dimethyl-5-(1-diethylamino-2-propylimino)-3-hexanonato-N,O,N')strontium.
Figure 8 is a drawing representative of the crystal structure of bis(2,2-dimethyl-5-(1-methylethylamino-2-propylimino)-3-hexanonato-N,O,N')strontium.
Figure 9 is a thermogravimetric analysis (TGA) and differential scanning calorimetry(DSC) diagram of bis(2,2-dimethyl-5-(1-methylethylamino-2-propylimino)-3-hexanonato-N,O,N')strontium, indicating the new Sr complex with a chiral center plus unsymmetrical substituents on the amino functionality has less than 5% residue and also a low melting point (~133°C).

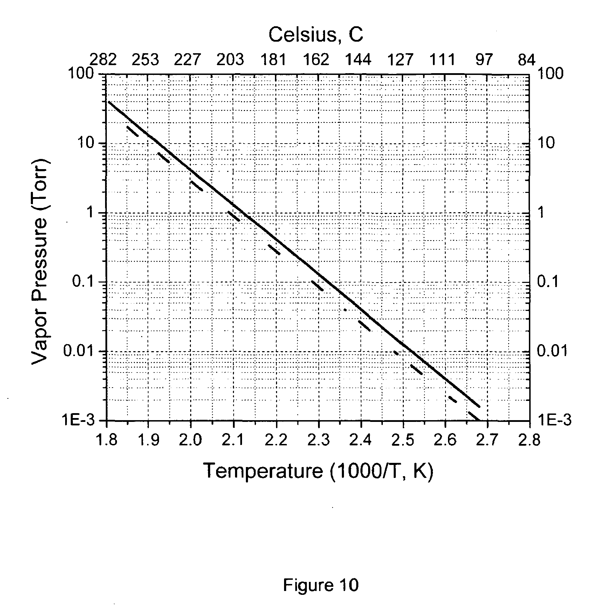

Figure 10 is a comparison of the vapor pressure of bis(2,2-dimethyl-5-(1-dimethylamino-2-propylimino)-3-hexanonato-N,O,N')strontium (solid line) vs bis(2,2-dimethyl-5-(dimethylaminoethyl-imino)-3-hexanonato-N,O,N')strontium (dashed line), indicating the new Sr complex with a chiral center (solid line) is more volatile than that without chiral center between the two nitrogen atoms (dashed line) even though the molecular weight of bis(2,2-dimethyl-5-(dimethylaminoethyl-imino)-3-hexanonato-N,O,N')strontium is smaller than that of bis(2,2-dimethyl-5-(1-dimethylamino-2-propylimino)-3-hexanonato-N,O,N')strontium.

### DETAILED DESCRIPTION OF THE INVENTION

This invention is related to metal-containing tridentate β-ketoiminate precursors and their solutions which are useful for fabricating conformal metal containing films on substrates such as silicon, metal nitride, metal oxide and other metal layers via deposition processes, e.g., Chemical Vapour Deposition (CVD) and Atomic Layer Deposition (ALD). Such conformal metal containing films have applications ranging from computer chips, optical device, magnetic information storage, to metallic catalyst coated on a supporting material. In contrast to prior tridentate β-ketoiminate precursors, the tridentate β-ketoiminate ligands incorporate at least one amino organo imino functionality (which is in contrast to the alkoxy groups reported in the literature as the donating ligand) and they contain a branched alkyl or alkylene bridge having at least one chiral carbon atom between the two nitrogen atoms.

Oxidizing agents for vapor deposition process include oxygen, hydrogen peroxide and ozone, and reducing agents for deposition processes include hydrogen, hydrazine, monoalkylhydrazine, dialkylhydrazine, and ammonia.

One type of structure in the metal precursor is illustrated in structure 1A below where the metal M has a valence of 2 having the formula: 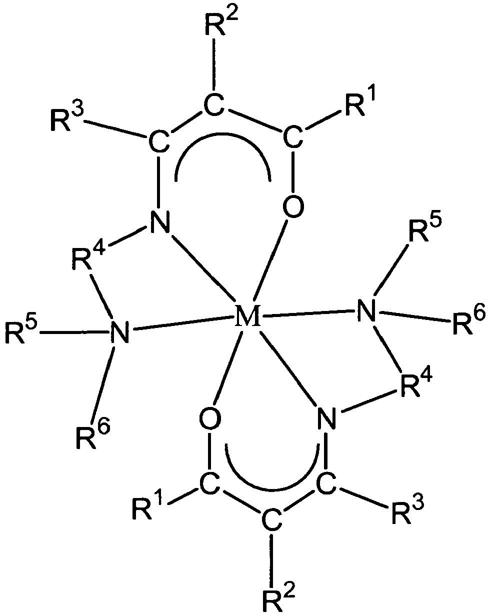 wherein M is selected from group 2, 8, 9, 10 metal atoms. In this precursor it is preferred that R¹ is a C₄₋₆ alkyl group, preferably a *t*-butyl or t-pentyl group when the metal is strontium and barium and C₁₋₆ when cobalt or nickel; R² is selected from hydrogen, C₁₋₆ alkyl, and C₆₋₁₀ aryl; R³ is selected from C₁₋₆ alkyl, C₁₋₆ fluoroalkyl, C₆₋₁₀ aryl; R⁵ and R⁶ are individually C₁₋₃ alkyl, preferably methyl groups and R⁴ is a C₃₋₁₀ branched alkyl or alkylene bridge having at least one chiral carbon atom, preferably a group containing 3 or 4 carbon atoms. Preferred metals are calcium, strontium, barium, iron, cobalt, and nickel.

Another type of structure within the first class of metal complexes containing tridentate β-ketoiminate ligands is illustrated in structure 2A below where the metal M has a valence of 3 having the formula: 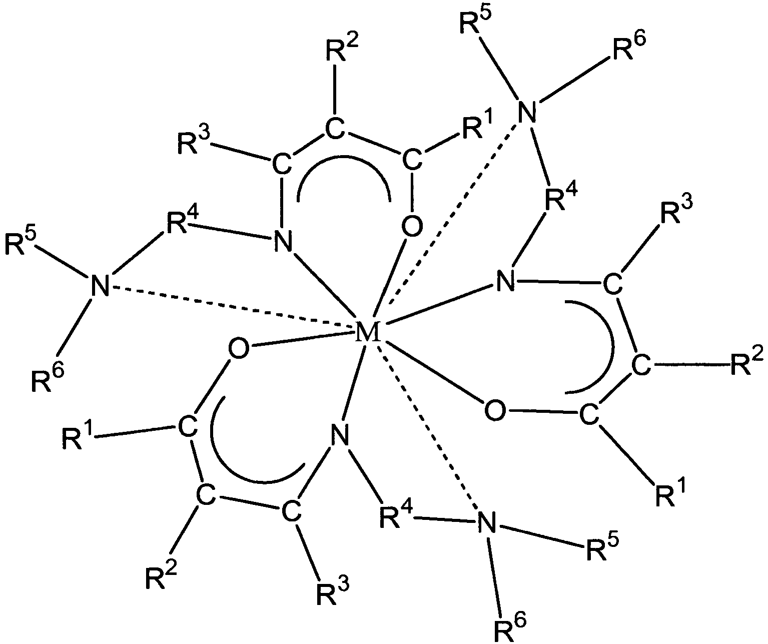 wherein M is selected from group 3 metal atoms. In this precursor it is preferred that R¹ is a C₄₋₆ alkyl group, preferably a *t*-butyl and t-pentyl group, R² is selected from hydrogen, C₁₋₆ alkyl, and C₆₋₁₀ aryl; R³ is selected from C₁₋₆ alkyl, C₁₋₆ fluoroalkyl, C₆₋₁₀ aryl, R⁵ and R⁶ are individually C₁₋₃ alkyl, preferably methyl groups, and R⁴ is a C₃₋₁₀ branched alkyl or alkylene bridge having at least one chiral carbon atom, preferably a group containing 3 or 4 carbon atoms. Preferred metals are scandium, yttrium, and lanthanum.

The second class of metal-containing precursors are comprised of tridentate β-ketoiminate ligands as shown in formula B: 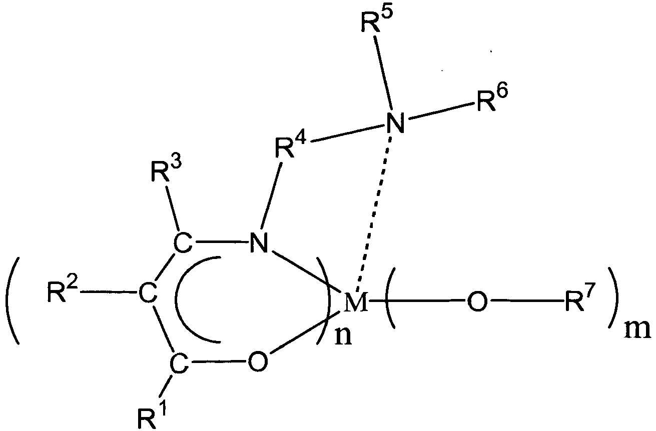 wherein M is a Group 4 or 5 metal such as titanium, zirconium, or hafnium. As shown the complex consists of at least one alkoxy ligand and a tridentate β-ketoiminato ligand having at least one amino organo imino functionality. The preferred R¹⁻⁶ groups are the same as in formula A. The preferred R⁷ group is a linear or branched alkyl, e.g., iso-propyl, n-butyl, *sec*-butyl, iso-butyl, and *tert*-butyl, m and n are at least 1 and the sum of m + n is equal to the valence of the metal

The tridentateβ-ketoiminate ligands can be prepared by well known procedure such as the Claisen condensation of a bulky ketone and an ethyl ester in presence of a strong base such as sodium amide or hydride, followed by another known procedure such as Schiff base condensation reaction with alkylaminoalkylamine. The ligands can be purified via vacuum distillation for a liquid or crystallization for solid.

As a preferred method for the formation of high yield and thermal stable tridentate ligands, it is preferred to choose a bulky R¹ group, e.g., C₄₋₆ alkyl groups without hydrogen attached to the carbon connected to the ketone functionality, the most preferred R¹ group being *tert*-butyl or *tert*-pentyl. The R¹ group prevents side reactions occurring in the following Schiff condensation and later protects the metal center from inter-molecular interaction. There is a competing issue and that is that the R¹⁻⁷ groups in the tridentate ligands should be as small as possible in order to decrease the molecular weight of the resulting metal-containing complexes and allow the achievement of complexes having a high vapor pressure. The preferred R⁴ is a branched alkyl or alkylene bridge having at least one chiral carbon atom, and is most preferably a group containing 3 or 4 carbon atoms in order to make the resulting complexes more stable via forming a five- or six-membered coordinating ring to the metal center. The chiral center in the ligand plays a crucial role in terms of lowering the melting point as well as increasing the thermal stability.

The metal-containing complexes can then be prepared via the reaction of the resulting tridentate ligands with pure metal, metal amide, metal hydride, or metal alkoxide. The metal-containing complexes can also be prepared via reacting the tridentate ligand with alkyl lithium or potassium hydride to provide the lithium or potassium salt of the ligand, then followed by reaction with metal halide, MXₙ ( X=Cl, Br, I; n=2,3). The group 4 and 5 mixed ligand complexes can be made via changing the ratio of metal alkoxide to the tridentate ligands.

These metal-containing complexes with tridentateβ-ketoiminate ligands can be employed as potential precursors to make thin metal or metal oxide films via either the chemical vapor deposition (CVD) or the atomic layer deposition (ALD) method at temperatures less than 500 °C. The CVD process can be carried out with or without reducing or oxidizing agents, whereas an ALD process usually involves the employment of another reactant such as a reducing agent or oxidizing agent.

For multi-component metal oxide, these complexes can be premixed if they have the same tridentate β-ketoiminate ligands. These metal-containing complexes with tridentate β-ketoiminate ligands can be delivered in vapor phase into a CVD or ALD reactor via well-known bubbling or vapor draw techniques. A direct liquid delivery method can also be employed by dissolving the complexes in a suitable solvent or a solvent mixture to prepare a solution with a molar concentration from 0.001 to 2 M depending the solvent or mixed-solvents employed.

The solvent employed in solubilizing the precursor for use in a deposition process may comprise any compatible solvent or their mixture including aliphatic hydrocarbons, aromatic hydrocarbons, ethers, esters, nitrites, and alcohols. The solvent component of the solution preferably comprises a solvent selected from: glyme solvents having from 1 to 20 ethoxy -(C₂H₄O)- repeat units; C₂-C₁₂ alkanols; organic ethers selected from dialkyl ethers comprising C₁-C₆ alkyl moieties, C₄-C₈ cyclic ethers, and C₁₂-C₆₀ crown O₄-O₂₀ ethers wherein the prefixed Cᵢ range is the number i of carbon atoms in the ether compound and the suffixed Oᵢ range is the number i of oxygen atoms in the ether compound; C₆-C₁₂ aliphatic hydrocarbons; C₆-C₁₈ aromatic hydrocarbons; organic esters; organic amines; polyamines; and organic amides.

Another class of solvents that offers advantages is the organic amide class of the form RCONR'R" wherein: R and R' are alkyl having from 1-10 carbon atoms or they can be connected to form with the C and N atoms of the amide a cyclic group (a lactam) having 4-6, preferably 5, members, wherein R and R' are together (CH₂)ₙ, wherein n is from 2-4, preferably 3; and R" is selected from alkyl having from 1 to 4 carbon atoms and cycloalkyl. N-methyl and N-cyclohexyl-2- pyrrolidinones, *N*,*N*-Diethylacetamide, and *N,N*-Diethylformamide are examples.

The following example illustrates the preparation of the metal-containing complexes with tridentate β-ketoiminate ligands as well as their use as precursors in metal-containing film deposition processes.

### Example 1

### Synthesis of 2,2-dimethyl-5-(1-dimethylamino-2-propylimino)-3-hexanone

To a solution of 13.55g (95.29mmol) 2,2-dimethyl-3,5-hexanedione in 150mL of tetrahydrofuran (THF) containing with 20g (140.81 mmol) of sodium sulfate was added 11.68g (114.34mmol) of 1-dimethylamino-2-propylamine. The reaction mixture was heated to 65°C for 72 hours. After completion, THF was evaporated under vacuum and excess 1-dimethylamino-2-propylamine was distilled by heating the mixture at 80°C under 140mTorr (19 Pa) vacuum for one hour. The residual oil was subjected to vacuum transfer heating at 110°C under 100mTorr (13 Pa) vacuum. 18.75g of a lime-green yellow oil was obtained and GC analysis indicates 99% purity. The yield was 87%.
¹H NMR (500 MHz, C₆D₆): δ= 11.51 (s, 1H), 5.20 (s, 1H), 3.24 (m, 1H), 1.91 (m, 2H), 1.91 (s, 6H), 1.60 (s, 3H), 1.32 (s, 9H), 0.94 (d, 3H).

### Example 2

### Synthesis of bis(2,2-dimethyl-5-(1-dimethylamino-2-propylimino)-3-hexanonato-N,O,N')strontium

To a solution of 1g (1.81mmol) Sr(N(SiMe₃)₂)₂(THF)₂ in 10mL THF was added 0.82g (3.62mmol) 2,2-dimethyl-5-(1-dimethylamino-2-propylimino)-3-hexanone in 10mL of THF dropwise at room temperature. After stirring at room temperature for 16 hours, THF was evaporated off under vacuum to provide an off-white solid that was taken up as a solution in hexanes. The hexanes were evaporated off and dry solid was recrystallized in pentane at room temperature. 0.48g of clear needle-like crystals were obtained (50% yield based on Sr).

Elemental analysis: calculated for C26H50N4O2Sr: C, 58.01; N, 10.40; H, 9.36. Found: C, 56.07; N, 10.10; H, 8.86. ¹H NMR (500 MHz, C₆D₆): δ= 5.12 (s, 1H), 3.42 (m, 1H), 3.32 (t, 1H), 1.96 (b, 2H), 1.83 (s, 6H), 1.72 (b, 2H), 1.41 (s, 9H), 0.94 (d, 3H).

A colorless crystal was structurally characterized by single crystal analysis. The structure shows strontium coordinated with two oxygen and four nitrogen atoms from the two tridentate ketoiminate ligands in a distorted octahedral environment.

This is illustrated in Figure 1 in which there are ethyl bridges between the two nitrogen atoms of the imino functionality for R⁴ shown as C4, C5 and C18, C17. C4 and C17 are chiral atoms as they are connected to four different substituents, i.e. H, N1, C11, C5 for C4 and H, N3, C18, C24 for C17.

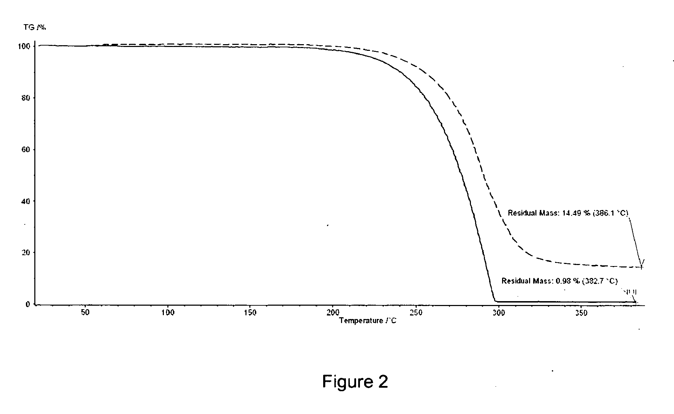

Figure 2 shows a TGA of the compound of Example 2 having ethyl bridges with chiral centers between the two nitrogen atoms of the imino functionality for R⁴; in contrast to the analogous compound where R⁴ is an ethyl bridge without chiral centers. The compound of Example 2 is shown by the solid line, while the analogous compound where R⁴ is an ethyl bridge is shown by the dotted line. A larger residue in a TGA analysis typifies compounds having less stability. Thus, the compound of Example 2 has less than 1% residue whereas the analogous compound without chiral centers over 14% residue, indicating a substantial enhancement in thermal stability which is advantageous for compounds for use as a precursor to deposit metal-containing films in a deposition in semiconductor fabrication.

### Example 3

### Synthesis of bis(2,2-dimethyl-5-(1-dimethylamino-2-propylimino)-3-hexanonato-N,O,N')nickel

To a solution of 3.49g (15.43mmol) 2,2-dimethyl-5-(1-dimethylamino-2-propylimino)-3-hexanone in 10mL of hexanes at -78°C in dry ice/acetone bath was added 6.17mL (15.43mmol) of 2.5M n-butyl lithium in hexanes dropwise. The solution was warmed to room temperature and left to stir for one hour. Hexanes were evaporated from solution under vacuum and a residual sticky yellow oil was obtained. 20mL of THF was added to the residual oil and this solution was added to 1.00g (7.72mmol) NiCl2 in 10mL of THF at room temperature and stirred for 96 hours under argon heating at 60°C. The THF was evaporated off under vacuum and the resulting residual dark green solid was taken up in hexanes, heated, and filtered. The hexanes were evaporated under vacuum and 3.5g of a sticky dark green solid was obtained that was sublimed at 100°C under 65mTorr (8.7 Pa) of vacuum for 48 hours yielding 2.8g of a green solid (70% yield). The sublimed material was recrystallized by slow evaporation of pentane at room temperature.

Elemential Anaylsis: calculated for C26H50N4NiO2: C, 61.30; H, 9.89; N, 11.00. Found: C, 59.18; H, 9.09; N, 10.84.

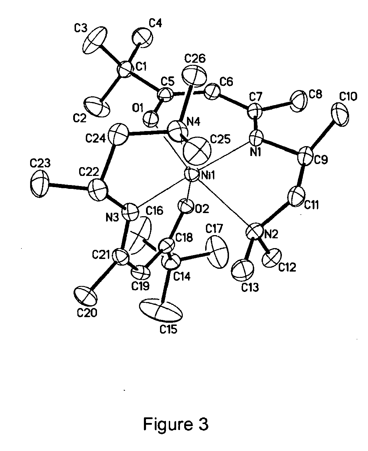

A dark green crystal was structurally characterized by single crystal analysis. The structure shows nickel coordinated with two oxygen and four nitrogen atoms from the two tridentate ketoiminate ligands in a distorted octahedral environment. This is illustrated in Figure 3 in which there are ethyl bridges between the two nitrogen atoms of the imino functionality for R⁴ shown as C9, C11 and C22, C24. C9 and C22 are chiral atoms as they are connected to four different substituents, i.e. H, N1, C10, C11 for C9 and H, N3, C23, C24 for C22.

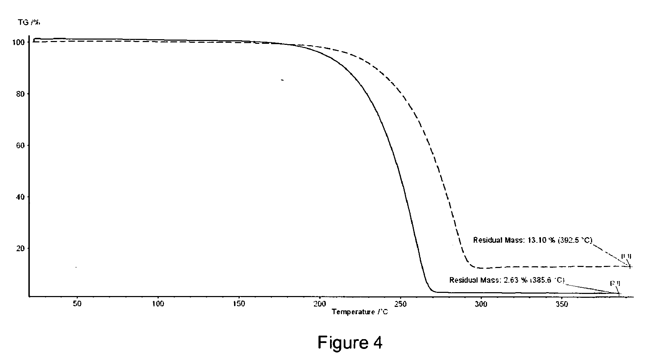

Figure 4 shows a TGA of the compound of Example 3 having ethyl bridges with chiral centers between the two nitrogen atoms of the imino functionality for R⁴; in contrast to the analogous compound where R⁴ is an ethyl bridge without chiral centers. The compound of Example 3 is shown by the solid line, while the analogous compound where R⁴ is an ethyl bridge without chiral centers is shown by the dotted line. A larger residue in a TGA analysis typifies compounds having less stability. Thus, the compound of Example 3 has approximately less than 3% residue whereas the analogous compound over 13% residue, indicating a substantial enhancement in thermal stability which is advantageous for compounds for use as a precursor to deposit metal-containing films in a deposition in semiconductor fabrication.

### Example 4

### Synthesis of Ti(O-Pr)₃(2,2-dimethyl-5-(1-dimethylamino-2-propylimino)-3-hexanonato

To a solution of 1 g (3.52mmol) titanium(IV)isopropoxide in 15mL of hexanes was added 0.80g (3.52mmol) 2,2-dimethyl-5-(1-dimethylamino-2-propylimino)-3-hexanone and reaction mixture was heated to 60°C for 16 hours. All volatiles were evaporated off under vacuum to provide 1.59g of a crude grainy oil.
¹H NMR (500 MHz, C₆D₆): δ= 5.32 (s, 1H), 5.10 (b, 3H), 3.20 (m, 1H), 2.40 (b, 2H), 2.40 (b, 6H), 1.64 (s, 3H), 1.39 (d, 18H), 1.36 (s, 9H), 1.27 (b, 3H).

### Example 5

### Synthesis of 4-(1-dimethylamino-2-propylimino)-2-pentanone

To a solution of 10g (199.76mmol) acetylacetone in THF at room temperature loaded with 20g of Na₂SO₄ was added 24.49g (239.71 mmol) 1-dimethylamino-2-propylamine. The slurry was stirred for 16 hours at room temperature and reaction deemed to be complete by GC/MS. All volatiles were evaporated off under vacuum and unreacted acetylacetone and diamine were removed by heating at 60°C under 100mTorr (13 Pa) vacuum for 2 hours. Yellow residual oil was purified via vacuum transfer heating at 130°C under 100mTorr (13 Pa) vacuum. 13.5g of light yellow oil was obtained as pure product with a yield of 74%.
¹H NMR (500 MHz, C₆D₆): δ= 11.25 (s, 1H), 4.90 (s, 1H), 3.22 (m, 1H), 2.06 (s, 3H), 1.96 (m, 2H), 1.93 (s, 6H), 1.54 (s, 3H), 0.92 (d, 3H).

### Example 6

### Synthesis of bis(4-(1-dimethylamino-2-propylimino)-2-pentanonato)strontium

To a solution of 1.0g (1.81mmol) Sr(N(SiMe₃)₂)₂(THF)₂ in 15ml of THF at room temperature was added 0.66g (3.62mmol) 4-(1-dimethylamino-2-propylimino)-2-pentanone. The reaction mixture was stirred for 16 hours. All volatiles were evaporated under vacuum to give rise to a foam-like solid that was dissolved in hexanes and evaporated again to give an off-white solid weighing 0.76g. Volatiles showed that reaction had occurred due to the presence of trimethylsilydiamine. Crude solid was dissolved in hot hexanes and filtered to provide a light yellow solution which underwent slow evaporation of hexanes at room temperature to generate clear crystals.

A colorless crystal was structurally characterized by single crystal analysis. The structure consists of two strontium atoms with four tridentate ketoiminate ligands in which each strontium atom is coordinated with four nitrogen atoms and three oxygen atoms.

### Example 7

### Bis(4-(1-dimethylamino-2-propylimino)-2-pentanonato)nickel

To a solution of 1.41g (7.72mmol) 4-(1-dimethylamino-2-propylimino)-2-pentanone in 15mL hexanes at -78°C was added 3.09mL (7.72mmol) nBu-Li dropwise. The solution was warmed up to room temperature and stirred for 30 minutes. All volatiles were evaporated off to give a sticky yellow oil that was taken up in 10mL THF. 0.5g (3.86mmol) NiCl₂ in 10ml THF was added to the resulting solution via canula. The beige NiCl₂ suspension turned dark after approximately 20 minutes. The suspension was heated at 50°C for 48 hours. All volatiles were evaporated off under vacuum to provide 1.7g of a grey solid that was sublimed for one week heating at 100°C under 65mTorr (8.7 Pa) vacuum. A green solid was collected and recrystallized by slow evaporation in pentane to give green crystals.

Elemental analysis: calculated for C20H38N4NiO2: C, 56.49; N, 13.18 ; H, 9.01. Found: C, 56.62; N, 13.19; H, 9.13.

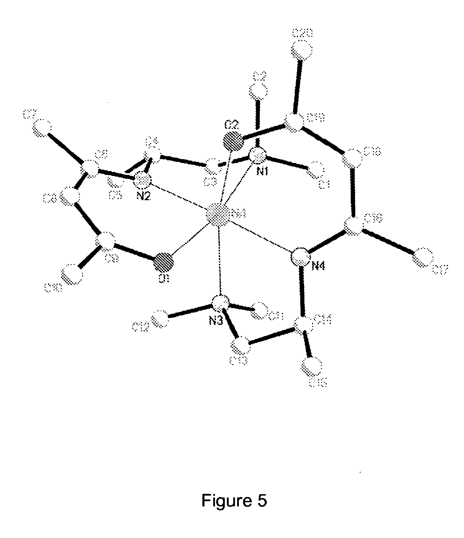

The X-ray single crystal analysis confirmed that it is a monomer in which the Ni atom is coordinated with two tridentate ketoiminate ligands in an octahedral environment. This is illustrated in Figure 5 in which the nickel atom is coordinated with four nitrogen atoms (N1, N2, N3, N4) and two oxygen atoms (01, 02). In this example, R¹=Me, R²=H, R³=Me, R⁵=R⁶=Me, and R⁴ is propyl comprising an ethyl bridge labeled as C3, C4 for one ligand and as C13, C14 for the other. C4 and C14 are chiral atoms because they are connected to four different substituents, i.e. H(ommited from the drawing), N2, C3, C5 in the case of C4, and H(ommited from the drawing), N4, C13, C15 in the case of C14.

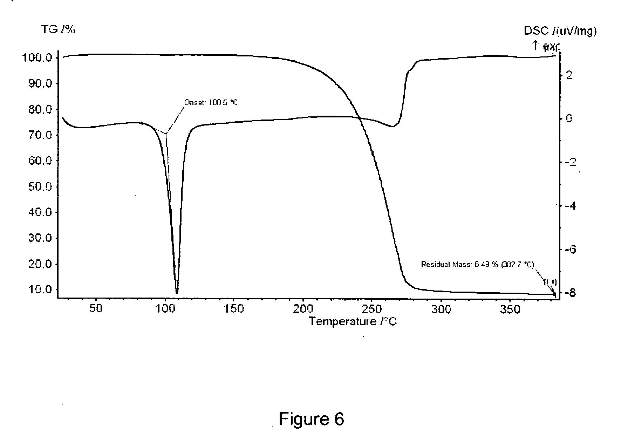

Figure 6 shows thermogravimetric analysis (TGA) and differential scanning calorimetry(DSC) diagrams for the compound of Example 7, indicating the complex with a chiral center is volatile with low residue and also a lower melting point (~100°C). The complex can be employed as a precursor to deposit nickel-containing films in CVD or ALD processes.

### Example 8

### Bis(4-(1-dimethylamino-2-propylimino)-2-pentanonato)cobalt

To a solution of 1.41g (7.70mmol) 4-(1-dimethylamino-2-propylimino)-2-pentanone in THF at -78°C was added 3.08mL (7.70mmol) 2.5M nBuLi in hexanes dropwise. The resulting slurry was warmed up to room temperature and stirred for 2 hours, then added to a flask loaded with 0.50g (3.85mmol) CoCl₂ in THF via canula. The reaction mixture turned coffee brown color immediately, which was kept at 50°C for two days. All volatiles were removed give a dark brown foam that was taken up in hexanes and evaporated to give 2.2g of a dark brown solid.

### Example 9

### Tri(isopropxoy)(4-(1-dimethylamino-2-propylimino)-2-pentanonato)titanium

To a solution of 1.00g (3.52mmol) titanium(IV) isopropoxide in 15 ml THF was added 0.65g (3.52mmol) 4-(1-dimethylamino-2-propylimino)-2-pentanone. The reaction mixture was stirred for 16 hours at room temperature and then THF was evaporated under vacuum. After work-up, 1.42 g grainy oil was obtained with a yield of 99%.

### Example 10

### Synthesis of 2,2-dimethyl-5-(1-diethylamino-2-propylimino)-3-hexanone

To a solution of 8.54g (60.06mmol) 2,2-dimethyl-3,5-hexanedione in 100 mL THF was added 8.60g (60.06mmol) 1-diethylamino-2-propylamine and 12g (84.48mmol) sodium sulfate. The reaction mixture was heated to 60°C for one week. All solids were removed and unreacted starting materials were distilled off via heating at 75°C under 100mTorr (13 Pa) vacuum for several hours. Short-path distillation provided 13.16g of lime green oil with a yield of 86%. GC measurement indicated it is >99% pure.
¹H NMR (500 MHz, C₆D₆): δ=11.51 (s, 1H), 5.20 (s, 1H), 3.24 (m, 1H), 2.24 (m, 4H), 2.15 (dd, 1H), 2.01 (dd, 1H), 1.64 (s, 3H), 1.33 (s, 9H), 0.95 (d, 3H), 0.82 (t, 6H).

### Example 11

### Synthesis of bis(2,2-dimethyl-5-(1-diethylamino-2-propylimino)-3-hexanonato-N,O,N')strontium

To a suspension of 1.00g (4.86mmol) strontium isopropoxide in 15mL THF at room temperature was added 2.60g (10.20mmol) ligand P in 15mL THF. The suspension turned solution-like after 10 minutes of stirring. After 16 hours of stirring at room temperature, the yellow-green solution was put under vacuum and THF evaporated off to give an oil. The oil was taken up as a solution in hexanes and evaporated again to give an oil weighing 3.03g. Upon slight heating, solid began to come out of the oil. This was heated into hexanes and filtered through syringe filter. 1.20g of clear crystals was collected to give a yield of 42%.

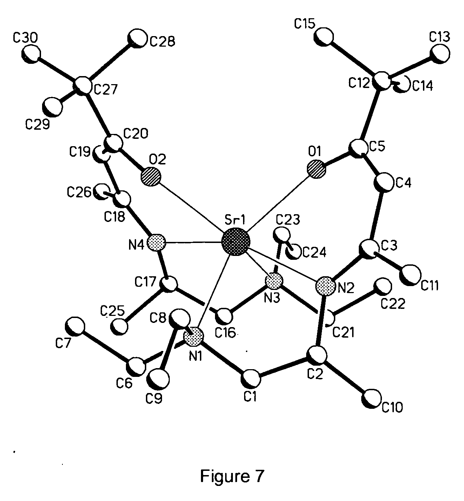

Elemental analysis: calculated for Sr(Me₃CCOCHCNMeCHCH₂NEt₂)₂: C, 60.62; N, 9.42; H, 9.83. Found: C, 60.26; N, 9.47; H, 9.28.
¹H NMR (500 MHz, C₆D₆): δ= 5.14 (s, 1H), 3.61 (m, 1H), 3.26 (t, 1H), 2.52 (m, 2H), 2.39 (b, 2H), 2.23 (dd, 1H), 1.87 (s, 3H), 1.41 (s, 9H), 1.02 (d, 3H), 0.76 (b, 6H).
A colorless crystal was structurally characterized by single crystal analysis. The structure shows the strontium atom is coordinated with two 2,2-diethyl-5-(1-diethylamino-2-propylimino)-3-hexanonato ligands in a distorted octahedral environment. This is illustrated in Figure 7 in which the strontium atom is coordinated with four nitrogen atoms (N1, N2, N3, N4) and two oxygen atoms (01, 02). In this example, R¹=Bu^{t}, R²=H, R³=Me, R⁵=R⁶=Et, and R⁴ is propyl comprising an ethyl bridge labeled as C1, C2 for one ligand and as C16, C17 for the other. C2 and C17 are chiral atoms because they are connected to four different substituents, i.e. H(ommited from the drawing), N2, C1, C10 for C2 and H(ommited from the drawing), N4, C16, C25 for C17.

### Example 12

### Synthesis of 2,2-dimethyl-5-(1-methylethylamino-2-propylimino)-3-hexanone

To a solution of 6.00g (42.19mmol) of 2,2-dimethyl-3,5-hexanedione in 75mL of THF was added 5.88g (50.63mmol) of 1-methylethylamino-2-followed by 10.00g sodium sulfate. The reaction mixture was heated to 72°C for 48 hours. GC indicated when the reaction was complete. THF was evaporated under vacuum. Left over diamine was distilled off by heating at 75°C under 150mTorr (20 Pa) vacuum for one hour. The residue was purified via vacuum transfer heating at 120°C under 100mTorr (13 Pa) vacuum. This gave a lime green oil weighing 9.21g. GC indicates a pure compound. 91% yield.
¹H NMR (500 MHz, C₆D₆): δ= 11.51 (s, 1H), 5.20 (s, 1H), 3.26 (m, 1H), 2.10 (m, 2H), 2.04 (dd, 1H), 1.97 (dd, 1H), 1.95 (s, 3H), 1.62 (s, 3H), 1.32 (s, 9H), 0.95 (d, 3H), 0.84 (t, 3H).

### Example 13

### Synthesis of bis(2,2-dimethyl-5-(1-methylethylamino-2-propylimino)-3-hexanonato-N,O,N')strontium

To a suspension of 1.00g (4.86mmol) Sr-isopropoxide in 45mL THF was added 2.45g (10.20mmol) ligand Q in 5mL THF. After approximately 20 minutes suspension turned into a solution. This was stirred at room temperature for 16 hours after which THF was evaporated under vacuum to give a yellow oil weighing 2.87g. The crude oil was subjected to vacuum transfer heating at 140°C under 100mTorr (13 Pa) vacuum for two hours to remove any free ligand. Ice-like residue was taken up in hexanes and a solid was retrieved by crashing it out at -40°C. Solid was recrystallized by heating into dodecane and yielded 1.10g of colorless crystals accounting for a 40% yield.
¹H NMR (500 MHz, C₆D₆): δ= 5.14 (s, 1H), 3.51 (m, 1H), 3.31 (b, 1H), 2.49 (b, 1H), 2.15 (b, 1H), 1.85 (s, 3H), 1.79 (b, 1H), 1.41 (s, 9H), 1.30 (s, 3H), 0.98 (d, 3H), 0.80 (b, 3H).

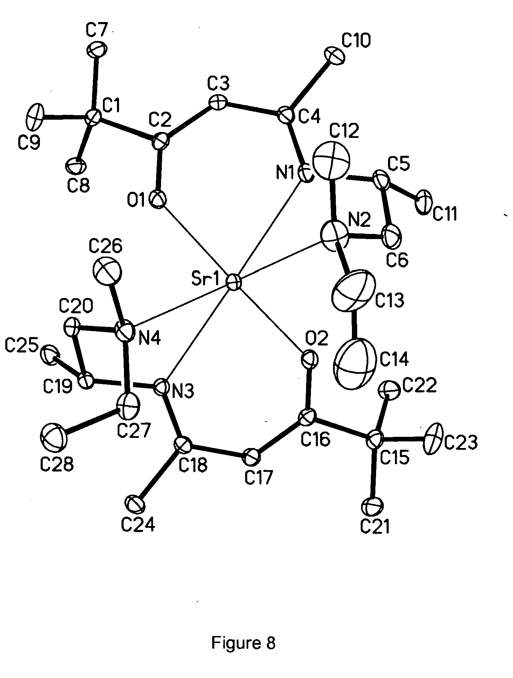

A colorless crystal was structurally characterized by single crystal analysis. The structure shows the strontium atom is coordinated with two 2,2-dimethyl-5-(1-methylethylamino-2-propylimino)-hexanonato ligands in a distorted octahedral environment. This is illustrated in Figure 8 in which the strontium atom is coordinated with four nitrogen atoms (N1, N2, N3, N4) and two oxygen atoms (01, 02). In this example, R¹=Bu^{t}, R²=H, R³=Me, R⁵=Me, R⁶=Et, and R⁴ is propyl comprising an ethyl bridge labeled as C5, C6 for one ligand and as C19, C20 for the other. C5 and C19 are chiral atoms because they are connected to four different substituents, i.e. H(ommited from the drawing), N1, C6, C11 for C5 and H(ommited from the drawing), N3, C20, C25 for C19.

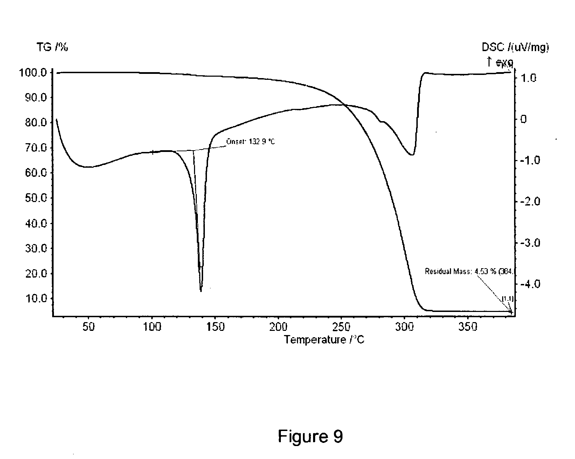

Figure 9 shows the thermogravimetric analysis (TGA) and differential scanning calorimetry(DSC) results for the compound of Example 13. The new Sr complex has a chiral center plus unsymmetrical substituents on the amino functionality. A larger residue in a TGA analysis typifies compounds having less thermal stability. Thus, the compound of Example 13 has approximately less than 5%, indicating a substantial enhancement in thermal stability which is advantageous when the compound is to be used as a precursor to deposit metal-containing films in a deposition in semiconductor fabrication. DSC indicates the compound has the lowest melting point (~133 C°) among tridentate β-ketoiminate strontium complexes synthesized so far. The enhanced thermal stability and the lowest melting point are most likely due to the chiral centers as well as unsymmetrical substituents on the amino functionality.

### Example 14

### Synthesis of Tris(4-(1-dimethylamino-2-propylimino)-2-pentanonato)lanthanum

To a solution of 0.52g (1.64mmol) Lanthanum (III) isopropoxide in 15mL THF was added 0.90g (4.93mmol) 4-(1-dimethylamino-2-propylimino)-2-pentanone in 5mL THF. The resulting slightly yellow solution was stirred for one hour at room temperature. Removal of all volatiles under vacuum yielded about 1.00g of a yellow solid with a yield of 88%.

### Example 15

### Synthesis of Tris(2,2-dimethyl-5-(1-dimethylamino-2-propylimino)-3-hexanonato)lanthanum

To a solution of 0.52g (1.64mmol) Lanthanum (III) isopropoxide in 15mL THF was added 1.12g (4.93mmol) 2,2-dimethyl-5-(1-dimethylamino-2-propylimino)-3-hexanone in 5mL THF. The resulting slightly yellow solution was stirred for 3 days at room temperature. Removal of all volatiles under vacuum yielded about 1.20g of a yellow solid with a yield of 90%.

### Example 16

### Synthesis of Tris(2,2-dimethyl-5-(1-dimethylamino-2-propylimino)-3-hexanonato)yttrium

To a foggy suspension of 1.00g (3.76mmol) Y-isopropoxide in 20mL THF was added 2.55g (11.27mmol) 2,2-dimethyl-5-(1-dimethylamino-2-propylimino)-3-hexanone in 5mL THF. The resulting foggy yellow solution was refluxed for 3 hours. Removal of all volatiles under vacuum yielded about 2.50g of a yellow solid with a yield of 87%.

One of the crucial requirements for precursors employed for chemical vapor deposition and atomic layer deposition is that the precursor has to be stable during the delivery temperature, generally ranging from 40 to 150°C. Thermogravimetric analysis (TGA) has been widely used as a tool to screen compounds. The measurements were carried out in open aluminum crucibles with sample size of 10 to 20 mg inside a dry box. The temperature ramp rate is usually 10C°/min. As the temperature increases, the compounds starts to undergo either vaporization or decomposition or both. Pure vaporization leads to almost no residue whereas vaporization plus decomposition results in a certain degree of residue. Generally speaking, less residue in a TGA diagram suggests the compound is more thermally stable, thus more suitable to be a precursor for fabricating thin films. As shown in Figure 2 and 4, the compounds revealed in this invention have much less residues than their prior analogues, suggesting they are more thermally stable and will serve as better precursors.

The introduction of chiral centers is one approach to increasing the thermal stability as well as lowering the melting point of resulting metal compounds. A molecule is chiral if it cannot be superimposed on its mirror image, the two mirror images of such a molecule are referred to as enantiomers. If a carbon atom has four different substituents connected to it, it is chiral. For compounds in Example 2 and 3, there are two chiral carbon atoms, implying there are three enantiomers co-existing in the solid state which scramble around, weakening intermolecular interactions, thus increasing the volatility of the compound. For example, as shown in Figure 10 bis(2,2-dimethyl-5-(dimethylaminoethyl-imino)-3-hexanonato-N,O,N')strontium is less volatile than bis(2,2-dimethyl-5-(1-dimethylamino-2-propylimino)-3-hexanonato-N,O,N')strontium, even though bis(2,2-dimethyl-5-(1-dimethylamino-2-propylimino)-3-hexanonato-N,O,N')strontium is larger and therefore might have been expected to be less volatile than bis(2,2-dimethyl-5-(dimethylaminoethyl-imino)-3-hexanonato-N,O,N')strontium.

## Claims

1. A metal containing complex represented by a structure selected from: 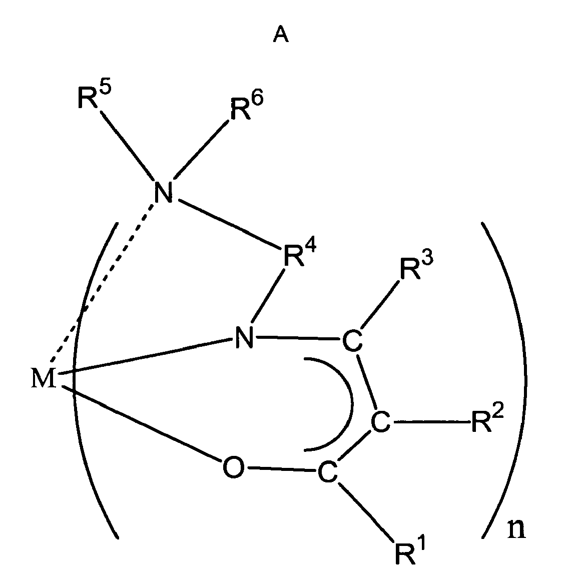 wherein M is a metal group having a valence of from 2 to 5; R¹ is selected from alkyl, alkoxyalkyl, fluoroalkyl, cycloaliphatic, and aryl, having from 1 to 10 carbon atoms; R² is selected from hydrogen, alkyl, alkoxy, cycloaliphatic, and aryl; R³ is selected from alkyl, alkoxyalkyl, fluoroalkyl, cycloaliphatic, and aryl; R⁴ is a C₃₋₁₀ branched alkyl or alkylene bridge having at least one chiral carbon atom; R⁵⁻⁶ are individually selected from alkyl, fluoroalkyl, cycloaliphatic, and aryl, or are connected thus forming a heterocyclic ring; and n is an integer equal to the valence of the metal M; and 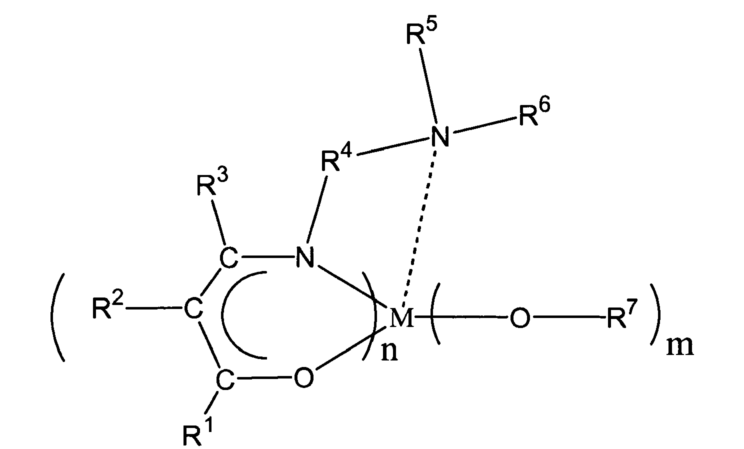 wherein M is a metal ion selected from Group 4 and 5 metals; R¹ is selected from alkyl, alkoxyalkyl, fluoroalkyl, cycloaliphatic, and aryl, having from 1 to 10 carbon atoms; R² is selected from hydrogen, alkyl, alkoxy, cycloaliphatic, and aryl; R³ is selected from alkyl, alkoxyalkyl, fluoroalkyl, cycloaliphatic, and aryl; R⁴ is a C₃₋₁₀ branched alkyl or alkylene bridge having at least one chiral carbon atom; R⁵⁻⁶ are individually selected from alkyl, fluoroalkyl, cycloaliphatic, and aryl, or are connected thus forming a heterocyclic ring; R⁷ is selected from alkyl, fluoroalkyl, cycloaliphatic, and aryl; m and n are each at least 1, and the sum of m plus n is equal to the valence of the metal M.

2. The metal containing complex of Claim 1, wherein: R¹ is a C₁₋₆ alkyl; R² is selected from hydrogen, a C₁₋₆ alkyl, and a C₆₋₁₀ aryl; R³ is selected from a C₁₋₆ alkyl, a C₁₋₆ fluoroalkyl, and a C₆₋₁₀ aryl; R⁴ is a C₃₋₄ branched alkyl or alkylene bridge having at least one chiral carbon atom; R⁵ is a C₁₋₃ alkyl; R⁶ is C₁₋₃ alkyl; and R⁷, where present, is a C₁₋₄ linear or branched alkyl.

3. The metal containing complex of Claim 1 or 2, structure A
wherein M is selected from calcium, magnesium, strontium, barium, scandium, yttrium, lanthanum, titanium, zirconium, vanadium, tungsten, manganese, cobalt, iron, nickel, ruthenium, zinc, copper, palladium, platinum, iridium, rhenium, and osmium.

4. The metal containing complex of Claim 3 wherein R¹ is selected from methyl, t-butyl and t-pentyl, R² is selected from hydrogen, methyl, and ethyl, R³ is selected from methyl and ethyl, R⁴ is a C₃ branched alkyl bridge with a chiral center, and R⁵ and R⁶ are individually selected from methyl and ethyl.

5. The metal containing complex of Claim 4 wherein:
M is strontium, R¹ is t-butyl, R² is hydrogen, R³ is methyl, R⁴ is 2-propyl, R⁵ is methyl or ethyl, and R⁶ is ethyl; or
M is cobalt or nickel, R¹ is methyl, R² is hydrogen, R³ is methyl, R⁴ is 2-propyl, and R⁵ and R⁶ are methyl.

6. The metal containing complex of Claim 1 or 2, represented by the structure B:
wherein M is selected from titanium, zirconium, hafnium, vanadium, niobium, and tantalum.

7. The metal containing complex of Claim 6 wherein R¹ is selected from C₁₋₅ alkyl, R² is selected from hydrogen, methyl, and ethyl, R³ is selected from methyl and ethyl, R⁴ is a C₃₋₄ alkyl or alkylene bridge with at least one chiral center, R⁵ and R⁶ are individually selected from methyl and ethyl, and R⁷ is selected methyl, ethyl, propyl, iso-propyl, *n*-butyl, *sec*-butyl, iso-butyl, and *tert*-butyl.

8. The metal containing complex of Claim 7 wherein: M is Ti, Hf or Zr, R¹ is methyl or t-butyl, R² is hydrogen, R³ is methyl, R⁴ is a branched C₃ alkyl bridge with one chiral center, and R⁵ and R⁶ are methyl.

9. The metal containing complex of any preceding claim dissolved in a solvent selected from: glyme solvents having from 1 to 20 ethoxy -(C₂H₄O)- repeat units; C₂-C₁₂ alkanols; organic ethers selected from dialkyl ethers comprising C₁-C₆ alkyl moieties, C₄-C₈ cyclic ethers; C₁₂-C₆₀ crown O₄-O₂₀ ethers wherein the prefixed Cᵢ range is the number i of carbon atoms in the ether compound and the suffixed Oᵢ range is the number i of oxygen atoms in the ether compound; C₆-C₁₂ aliphatic hydrocarbons; C₆-C₁₈ aromatic hydrocarbons; organic esters; organic amines; polyamines; and organic amides.

10. The metal containing complex of Claim 9 wherein the solvent is an organic amide selected from N-methyl-2-pyrrolidinone, N-ethyl-2-pyrrolidinone, N-cyclohexyl-2-pyrrolidinone, *N,N*-Diethylacetamide, and *N,N*-Diethylformamide.

11. A vapor deposition process for forming a conformal metal oxide thin film on a substrate wherein a precursor source and an oxygen containing agent are introduced to a deposition chamber and a metal oxide film deposited on a substrate, the precursor source comprising a metal containing complex as claimed in any one of Claims 1 to 10.

12. The vapor deposition process of Claim 11 wherein the oxygen containing agent is selected from water, O₂, H₂O₂, ozone, O₂ plasma, H₂O plasma, and mixtures thereof.

13. A vapor deposition process for forming a conformal metal thin film on a substrate wherein a precursor source and a reducing agent are introduced to a deposition chamber and a metal film deposited on a substrate, the precursor source comprising a metal containing complex as claimed in any one of Claims 1 to 10.

14. The vapor deposition process of Claim 13 wherein the reducing agent is selected from hydrogen, hydrazine, monoalkylhydrazine, dialkylhydrazine, ammonia, and mixtures thereof.

15. The vapor deposition process of any one of Claims 11 to 14 wherein the vapor deposition process is selected from chemical vapor deposition, plasma enhanced chemical vapor deposition, atomic layer deposition, and plasma enhanced atomic layer deposition.

## Patentansprüche

1. Metallhaltiger Komplex, der mit einer Struktur angegeben wird, die ausgewählt ist aus: 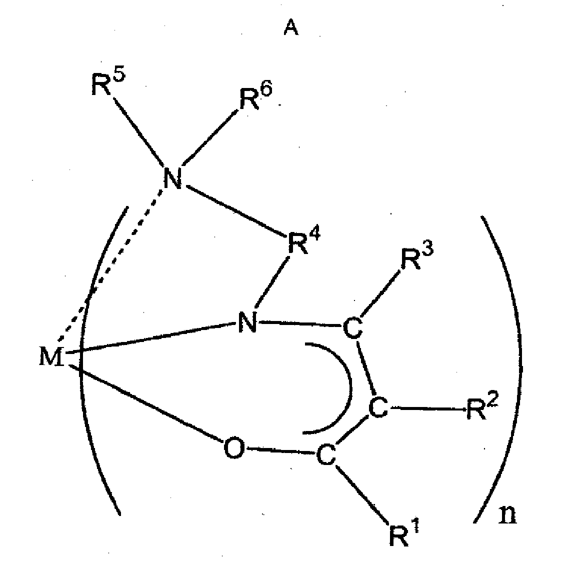 worin M ein Metallgruppe mit einer Wertigkeit von 2 bis 5 ist; R¹ aus Alkyl, Alkoxyalkyl, Fluoralkyl, einem cycloaliphatischen Rest und Aryl mit 1 bis 10 Kohlenstoffatomen ausgewählt ist; R² aus Wasserstoff, Alkyl, Alkoxy, einem cycloaliphatischen Rest und Aryl ausgewählt ist; R³ aus Alkyl, Alkoxyalkyl, Fluoralkyl, einem cycloaliphatischen Rest und Aryl ausgewählt ist; R⁴ eine Brücke aus einem verzweigten C₃₋₁₀-Alkyl oder Alkylen mit mindestens einem chiralen Kohlenstoffatom ist; R⁵⁻⁶ jeweils einzeln aus Alkyl, Fluoralkyl, einem cycloaliphatischen Rest und Aryl ausgewählt sind oder verbunden sind, womit ein heterocyclischer Ring gebildet wird; und n eine ganze Zahl ist, die gleich der Wertigkeit des Metalls M ist; und 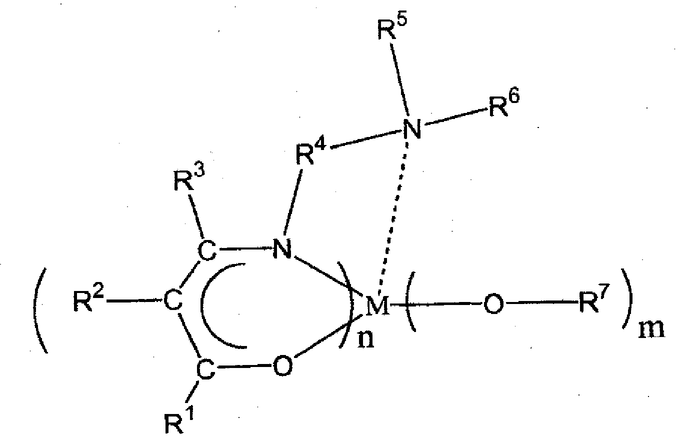 worin M ein Metallion ist, das aus Metallen der Gruppen 4 und 5 ausgewählt ist; R¹ aus Alkyl, Alkoxyalkyl, Fluoralkyl, einem cycloaliphatischen Rest und Aryl mit 1 bis 10 Kohlenstoffatomen ausgewählt ist; R² aus Wasserstoff, Alkyl, Alkoxy, einem cycloaliphatischen Rest und Aryl ausgewählt ist; R³ aus Alkyl, Alkoxyalkyl, Fluoralkyl, einem cycloaliphatischen Rest und Aryl ausgewählt ist; R⁴ eine Brücke aus einem verzweigten C₃₋₁₀-Alkyl oder Alkylen mit mindestens einem chiralen Kohlenstoffatom ist; R⁵⁻⁶ jeweils einzeln aus Alkyl, Fluoralkyl, einem cycloaliphatischen Rest und Aryl ausgewählt sind oder verbunden sind, wodurch ein heterocyclischer Ring gebildet wird; R⁷ aus Alkyl, Fluoralkyl, einem cycloaliphatischen Rest und Aryl ausgewählt ist; m und n jeweils mindestens 1 sind und die Summe von m plus n gleich der Wertigkeit des Metalls M ist.

2. Metallhaltiger Komplex nach Anspruch 1, wobei: R¹ C₁₋₆-Alkyl ist; R² aus Wasserstoff, C₁₋₆-Alkyl und C₆₋₁₀-Aryl ausgewählt ist; R³ aus C₁₋₆-Alkyl, C₁₋₆-Fluoralkyl und C₆₋₁₀-Aryl ausgewählt ist; R⁴ eine Brücke aus einem verzweigten C₃₋₄-Alkyl oder Alkylen mit mindestens einem chiralen Kohlenstoffatom ist; R⁵ C₁₋₃-Alkyl ist; R⁶ C₁₋₃-Alkyl ist; und R⁷, falls vorhanden, eine lineare oder verzweigte C₁₋₄-Alkylgruppe ist.

3. Metallhaltiger Komplex nach Anspruch 1 oder 2, Struktur A, wobei M aus Calcium, Magnesium, Strontium, Barium, Scandium, Yttrium, Lanthan, Titan, Zirconium, Vanadium, Wolfram, Mangan, Cobalt, Eisen, Nickel, Ruthenium, Zink, Kupfer, Palladium, Platin, Iridium, Rhenium und Osmium ausgewählt ist.

4. Metallhaltiger Komplex nach Anspruch 3, wobei R¹ aus Methyl, t-Butyl und t-Pentyl ausgewählt ist, R² aus Wasserstoff, Methyl und Ethyl ausgewählt ist, R³ aus Methyl und Ethyl ausgewählt ist, R⁴ eine Brücke aus einem verzweigten C₃-Alkyl mit einem chiralen Zentrum ist und R⁵ und R⁶ jeweils einzeln aus Methyl und Ethyl ausgewählt sind.

5. Metallhaltiger Komplex nach Anspruch 4, wobei:
M Strontium ist, R¹ t-Butyl ist, R² Wasserstoff ist, R³ Methyl ist, R⁴ 2-Propyl ist, R⁵ Methyl oder Ethyl ist und R⁶ Ethyl ist; oder
M Cobalt oder Nickel ist, R¹ Methyl ist, R² Wasserstoff ist, R³ Methyl ist, R⁴ 2-Propyl ist und R⁵ und R⁶ Methyl sind.

6. Metallhaltiger Komplex nach Anspruch 1 oder 2, der mit der Struktur B angegeben wird:
wobei M aus Titan, Zirconium, Hafnium, Vanadium, Niob und Tantal ausgewählt ist.

7. Metallhaltiger Komplex nach Anspruch 6, wobei R¹ aus C₁₋₅-Alkyl ausgewählt ist, R² aus Wasserstoff, Methyl und Ethyl ausgewählt ist, R³ aus Methyl und Ethyl ausgewählt ist, R⁴ eine Brücke aus einem C₃₋₄-Alkyl oder Alkylen mit mindestens einem chiralen Zentrum ist, R⁵ und R⁶ jeweils einzeln aus Methyl und Ethyl ausgewählt sind und R⁷ aus Methyl, Ethyl, Propyl, Isopropyl, n-Butyl, sek.-Butyl, Isobutyl und tert.-Butyl ausgewählt ist.

8. Metallhaltiger Komplex nach Anspruch 7, wobei:
M gleich Ti, Hf oder Zr ist, R¹ Methyl oder t.-Butyl ist, R² Wasserstoff ist, R³ Methyl ist, R⁴ eine Brücke aus einem verzweigten C₃-Alkyl mit einem chiralen Zentrum ist, R⁵ und R⁶ Methyl sind

9. Metallhaltiger Komplex nach einem der vorstehenden Ansprüche, der in einem Lösungsmittel gelöst ist, das ausgewählt ist aus:
Glycolether-Lösungsmitteln mit 1 bis 20 Ethoxy-(C₂H₄O)-St tureinheiten; C₂-C₁₂-Alkanolen; organischen Ethern, die ausgewählt sind aus Dialkylethern, die C₁-C₆-Alkyleinheiten aufweisen, cyclischen C₄-C₈-Ethern; C₁₂-C₆₀-Kronen-O₄-O₂₀-ethern,
wobei der mit einem Präfix versehene Ci-Bereich die Anzahl i der Kohlenstoffatome der Etherverbindung ist und der mit einem Index versehene Oi-Bereich die Anzahl i der Sauerstoffatome in der Etherverbindung ist; aliphatischen C₆-C₁₂-Kohlenwasserstoffen; aromatischen C₆-C₁₈-Kohlenwasserstoffen; organischen Estern; organischen Aminen; Polyaminen; und organischen Amide.

10. Metallhaltiger Komplex nach Anspruch 9, wobei das Lösungsmittel ein organisches Amid ist, das ausgewählt ist aus N-Methyl-2-pyrrolidinon, N-Ethyl-2-pyrrolidinon, N-Cyclohexyl-2-pyrrolidinon, N,N-Diethylacetamid und N,N-Diethylformamid.

11. Aufdampfungsverfahren zum Erzeugen einer konformen Metalloxid-Dünnschicht auf einem Substrat, wobei eine Quelle einer Vorläuferverbindung und ein sauerstoffhaltiges Mittel in eine Abscheidekammer eingeführt werden und auf einem Substrat eine Metalloxidschicht aufgetragen wird, wobei die Quelle der Vorläuferverbindung einen metallhaltigen Komplex nach einem der Ansprüche 1 bis 10 umfaßt.

12. Aufdampfungsverfahren nach Anspruch 11, wobei das sauerstoffhaltige Mittel aus Wasser, O₂, H₂O₂, Ozon, O₂-Plasma, H₂O-Plasma und Gemischen davon ausgewählt ist.

13. Aufdampfungsverfahren zum Erzeugen einer konformen Metall-Dünnschicht auf einem Substrat, wobei eine Quelle einer Vorläuferverbindung und ein Reduktionsmittel in eine Abscheidekammer eingeführt werden und auf einem Substrat eine Metallschicht aufgetragen wird, wobei die Quelle der Vorläuferverbindung einen metallhaltigen Komplex nach einem der Ansprüche 1 bis 10 umfaßt.

14. Aufdampfungsverfahren nach Anspruch 13, wobei das Reduktionsmittel aus Wasserstoff, Hydrazin, Monoalkylhydrazin, Dialkylhydrazin, Ammoniak und Gemischen davon ausgewählt ist.

15. Aufdampfungsverfahren nach einem der Ansprüche 11 bis 14, wobei das Aufdampfungsverfahren aus einem chemischen Aufdampfen, einem plasmagestützten chemischen Aufdampfen, dem Atomlagenabscheiden und dem plasmagestützten Atomlagenabscheiden ausgewählt ist.

## Revendications

1. Complexe contenant un métal représenté par une structure choisie parmi : 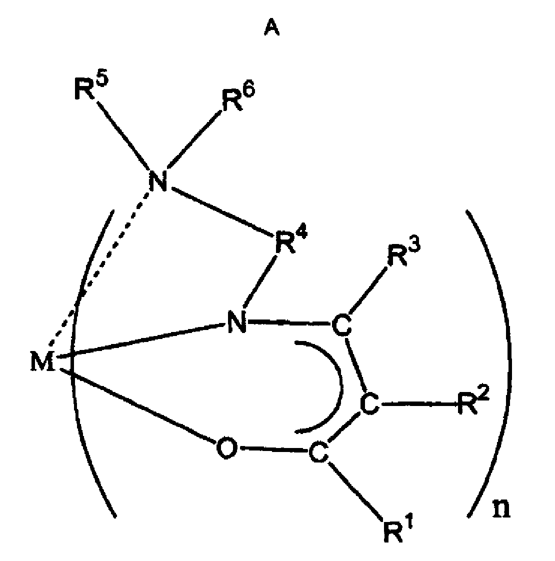 où M est un groupe métallique ayant une valence de 2 à 5; R¹ est choisi parmi alkyle, alcoxyalkyle, fluoroalkyle, cycloaliphatique et aryle, ayant de 1 à 10 atomes de carbone; R² est choisi parmi l'hydrogène, alkyle, alcoxy, cycloaliphatique et aryle; R³ est choisi parmi alkyle, alcoxyalkyle, fluoroalkyle, cycloaliphatique et aryle; R⁴ est un pont C₃₋₁₀ alkyle ou alkylène ramifié ayant au moins un atome de carbone chiral; R⁵⁻⁶ sont choisis individuellement parmi alkyle, fluoroalkyle, cycloaliphatique et aryle, ou sont liés en formant un cycle hétérocyclique; et n est un entier égal à la valence du métal M; et 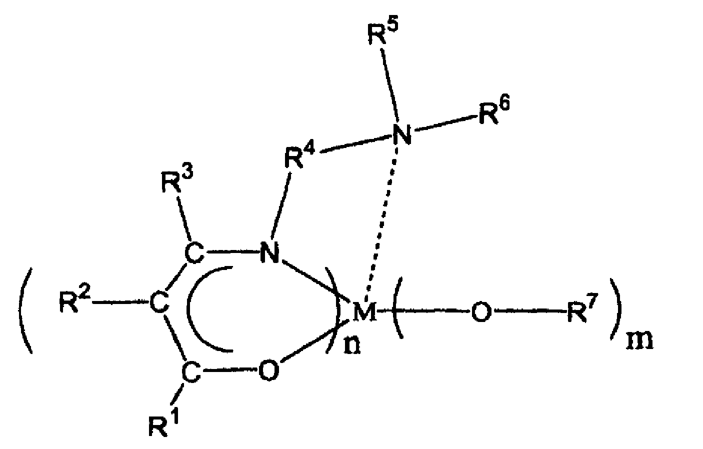 où M est un ion métallique choisi parmi les métaux des groupes 4 et 5; R¹ est choisi parmi alkyle, alcoxyalkyle, fluoroalkyle, cycloaliphatique et aryle, ayant de 1 à 10 atomes de carbone; R² est choisi parmi l'hydrogène, alkyle, alcoxy, cycloaliphatique et aryle; R³ est choisi parmi alkyle, alcoxyalkyle, fluoroalkyle, cycloaliphatique et aryle; R⁴ est un pont C₃₁₀ alkyle ou alkylène ramifié ayant au moins un atome de carbone chiral; R⁵⁻⁶ sont choisis individuellement parmi alkyle, fluoroalkyle, cycloaliphatique et aryle, ou sont liés en formant un cycle hétérocyclique; R⁷ est choisi parmi alkyle, fluoroalkyle, cycloaliphatique et aryle; m et n sont chacun au moins 1, et la somme de m plus n est égale à la valence du métal M.

2. Complexe contenant un métal selon la revendication 1, où: R¹ est un C₁₋₆ alkyle; R² est choisi parmi l'hydrogène, un C₁₋₆ alkyle et un C₆₋₁₀ aryle; R³ est choisi parmi un C₁₋₆ alkyle, un C₁₋₆ fluoroalkyle et un C₆₋₁₀ aryle; R⁴ est un pont C₃-₄ alkyle ou alkylène ramifié ayant au moins un atome de carbone chiral; R⁵ est un C₁₋₃ alkyle; R⁶ est C₁₋₃ alkyle; et R⁷, quand il est présent, est un C₁₋₄ alkyle linéaire ou ramifié.

3. Complexe contenant un métal selon la revendication 1 ou 2, structure A
où M est choisi parmi le calcium, le magnésium, le strontium, le baryum, le scandium, l'yttrium, le lanthane, le titane, le zirconium, le vanadium, le tungstène, le manganèse, le cobalt, le fer, le nickel, le ruthénium, le zinc, le cuivre, le palladium, le platine, l'iridium, le rhénium et l'osmium.

4. Complexe contenant un métal selon la revendication 3 où R¹ est choisi parmi méthyle, t-butyle et t-pentyle, R² est choisi parmi l'hydrogène, méthyle et éthyle, R³ est choisi parmi méthyle et éthyle, R⁴ est un pont C₃ alkyle ramifié avec un centre chiral, et R⁵ et R⁶ sont choisis individuellement parmi méthyle et éthyle.

5. Complexe contenant un métal selon la revendication 4 où:
M est le strontium, R¹ est t-butyle, R² est l'hydrogène, R³ est méthyle, R⁴ est 2-propyle, R⁵ est méthyle ou éthyle et R⁶ est éthyle; ou
M est le cobalt ou le nickel, R¹ est méthyle, R² est l'hydrogène, R³ est méthyle, R⁴ est 2-propyle et R⁵ et R⁶ sont méthyle.

6. Complexe contenant un métal selon la revendication 1 ou 2, représenté par la structure B:
où M est choisi parmi le titane, le zirconium, le hafnium, le vanadium, le niobium et le tantale.

7. Complexe contenant un métal selon la revendication 6 où R¹ est choisi parmi C₁₋₅ alkyle, R² est choisi parmi l'hydrogène, méthyle et éthyle, R³ est choisi parmi méthyle et éthyle, R⁴ est un pont C₃₋₄ alkyle ou alkylène avec au moins un centre chiral, R⁵ et R⁶ sont choisis individuellement parmi méthyle et éthyle, et R⁷ est choisi parmi méthyle, éthyle, propyle, iso-propyle, n-butyle, sec-butyle, isobutyle et tert-butyle.

8. Complexe contenant un métal selon la revendication 7 où: M est Ti, Hf ou Zr, R¹ est méthyle ou t-butyle, R² est l'hydrogène, R³ est méthyle, R⁴ est un pont C₃ alkyle ramifié avec un centre chiral, et R⁵ et R⁶ sont méthyle.

9. Complexe contenant un métal selon l'une quelconque des revendications précédentes dissous dans un solvant choisi parmi: les solvants glymes ayant de 1 à 20 unités répétées éthoxy -(C₂H₄O)- ; les C₂-C₁₂ alcanols; les éthers organiques choisis parmi les dialkyléthers comprenant des groupements C₁-C₆ alkyle, les éthers C₄-C₈ cycliques ; les 0₄-O₂₀ éthers C₁₂-C₆₀ couronnes où la plage suffixée Cᵢ est le nombre i d'atomes de carbone dans le composé éther et la plage préfixée Oᵢ est le nombre i d'atomes d'oxygène dans le composé éther ; les hydrocarbures C₆-C₁₂ aliphatiques ; les hydrocarbures C₆-C₁₈ aromatiques ; les esters organiques ; les amines organiques ; les polyamines ; et les amides organiques.

10. Complexe contenant un métal selon la revendication 9 où le solvant est un amide organique choisi parmi la N-méthyl-2-pyrrolidinone, la N-éthyl-2-pyrrolidinone, la N-cyclohexyl-2-pyrrolidinone, le *N,N*-diéthylacétamide et le *N,N* diéthylformamide.

11. Procédé de dépôt en phase vapeur pour former un film mince d'oxyde métallique conforme sur un substrat où une source de précurseur et un agent contenant de l'oxygène sont introduits dans une chambre de dépôt et un film d'oxyde métallique déposé sur un substrat, la source de précurseur comprenant un complexe contenant un métal selon l'une quelconque des revendications 1 à 10.

12. Procédé de dépôt en phase vapeur selon la revendication 11 où l'agent contenant de l'oxygène est choisi parmi l'eau, O₂, H₂O₂, l'ozone, un plasma de O₂, un plasma de H₂O et leurs mélanges.

13. Procédé de dépôt en phase vapeur pour former un film mince métallique conforme sur un substrat où une source de précurseur et un agent réducteur sont introduits dans une chambre de dépôt et un film métallique déposé sur un substrat, la source de précurseur comprenant un complexe contenant un métal selon l'une quelconque des revendications 1 à 10.

14. Procédé de dépôt en phase vapeur selon la revendication 13 où l'agent réducteur est choisi parmi l'hydrogène, l'hydrazine, une monoalkylhydrazine, une dialkylhydrazine, l'ammoniac et leurs mélanges.

15. Procédé de dépôt en phase vapeur selon l'une quelconque des revendications 11 à 14 où le procédé de dépôt en phase vapeur est choisi parmi le dépôt chimique en phase vapeur, le dépôt chimique en phase vapeur assisté par plasma, le dépôt par couche atomique et le dépôt par couche atomique assisté par plasma.
